# EUROPÄISCHE PATENTSCHRIFT

(11) **EP 0 394 753 B1**
(45) Veröffentlichungstag und Bekanntmachung des Hinweises auf die Patenterteilung: **28.12.1994**
(21) Anmeldenummer: 90106912.0
(22) Anmeldetag: 11.04.1990
(51) Int. Cl.: H01R 13/645

(54) **Codiervorrichtung für auf eine Rückwandverdrahtung aufsteckbare elektrische Baugruppen**
Coding device for electrical assemblies pluggable on a back panel wiring
Dispositif de codage pour assemblages électriques enfichables sur un câblage de panneau arrière

(30) Priorität: 27.04.1989 DE 8905362 U
(43) Veröffentlichungstag der Anmeldung: 31.10.1990
(73) Patentinhaber: SIEMENS AKTIENGESELLSCHAFT, 80333 München (DE)
(72) Erfinder: Zell, Karl, Dipl.-Ing. (FH), D-8130 Niederpöcking (DE); Pelzl, Leo, Dipl.-Ing. (FH), D-8150 Holzkirchen (DE)

(56) Entgegenhaltungen:
- EP-A- 0 195 955
- DE-A- 2 743 033
- DE-U- 8 428 477
- US-A- 4 167 032

## Beschreibung

Die Erfindung betrifft eine Codiervorrichtung für auf eine Rückwandverdrahtung aufsteckbare elektrische Baugruppen, wobei die Rückwandverdrahtung aus einer Rückwandleiterplatte mit im durchgehenden Raster eingesetzten Kontaktmessern und darauf aufsteckbaren, als einseitig offene, rechtwinklige Gehäuse ausgebildeten Messerleisten zur Aufnahme von Federleisten, die mit elektrischen Baugruppen fest verbunden sind, besteht.

Derartige Rückwandverdrahtungen sind z. B. aus dem deutschen Gebrauchsmuster 85 09 375 bekannt. Ihr Vorteil besteht darin, daß bei einer vollständig mit rasterförmig angeordneten Stiften belegten Rückwandleiterplatte eine einzige Ausführungsform für alle sich möglicherweise ergebenden Anforderungen genügt.

Für derartige Rückwandverdrahtungen sind die herkömmlichen Codiervorrichtungen nicht geeignet, da ein Teil der Codiervorrichtung neben der Messerleiste angeordnet sein muß, und damit eine vollständig mit rasterförmig angeordneten Stiften belegte Rückwandleiterplatte nicht mehr realisierbar ist. Eine derartige herkömmliche Codiervorrichtung für eine aus Messer- und Federleiste bestehende Steckverbindung, die bei der hier vorausgesetzten Rückwandverdrahtung nicht anwendbar ist, ist z. B. aus dem deutschen Gebrauchsmuster 84 28 477 bekannt.

Aufgabe der vorliegenden Erfindung ist es, eine Codiervorrichtung der eingangs genannten Art anzugeben, die bei einer Rückwandleiterplatte mit im durchgehenden Raster eingesetzten Kontaktmessern nachträglich ohne Änderung der Rückwandleiterplatte an Messer- und Federleiste angebracht werden kann.

Diese Aufgabe wird erfindungsgemäß für eine Codiervorrichtung der oben genannten Art dadurch gelöst, daß neben den Messerleisten Codierleisten auf die Rückwandleiterplatte aufsteckbar sind, die sowohl Vertiefungen zur Aufnahme von an den Federleisten angebrachten und in Steckrichtung zeigenden Codierstiften als auch Vertiefungen zur Aufnahme der Kontaktmesser aufweisen.

Da bei der erfindungsgemäßen Codiervorrichtung die neben den Messerleisten angeordneten Codierleisten zusätzliche Vertiefungen zur Aufnahme der Kontaktmesser aufweisen, kann die erfindungsgemäße Codiervorrichtung für Rückwandleiterplatten mit im durchgehenden Raster eingesetzten Kontaktmessern verwendet werden, da bei der Benutzung der erfindungsgemäßen Codiervorrichtung keine der vorhandenen Kontaktmesser entfernt werden müssen.

Eine zweckmäßige Weiterbildung der erfindungsgemäßen Codiervorrichtung ist dadurch gekennzeichnet, daß die Codierstifte Teile einer an dem Federleistenkörper anbringbaren Gegencodierleiste sind. Auf diese Weise kann bei der Herstellung der Baugruppe auf einfache Weise durch Anbringen einer einzigen Leiste eine Codierung vorgegeben werden.

Eine andere zweckmäßige Weiterbildung der erfindungsgemäßen Codiervorrichtung ist dadurch gekennzeichnet, daß die Codierstifte einzeln in im Federleistenkörper vorgesehenen Nuten einsetzbar sind. Hierdurch erhöht sich zwar der Aufwand bei der Herstellung einer Codierung, jedoch ist auf diese Weise eine individuelle Änderung der Codierung leicht möglich.

Im folgenden wird die Erfindung anhand eines in der Zeichnung dargestellten Ausführungsbeispiels näher erläutert.

Es zeigen:
- FIG 1: die perspektivische Ansicht eines Teils einer Rückwandleiterplatte mit Kontaktmesser und Zentrierleiste sowie Teile einer dazu gehörigen Baugruppe mit einer Federleiste,
- FIG 2: einen Querschnitt durch eine Codiervorrichtung mit am Federleistenkörper angebrachten Codierstiften, und
- FIG 3: einen Querschnitt durch eine Codiervorrichtung mit an der Leiterplatte der Baugruppe im Flanschbereich des Federleistenkörpers angebrachten Codierstiften.

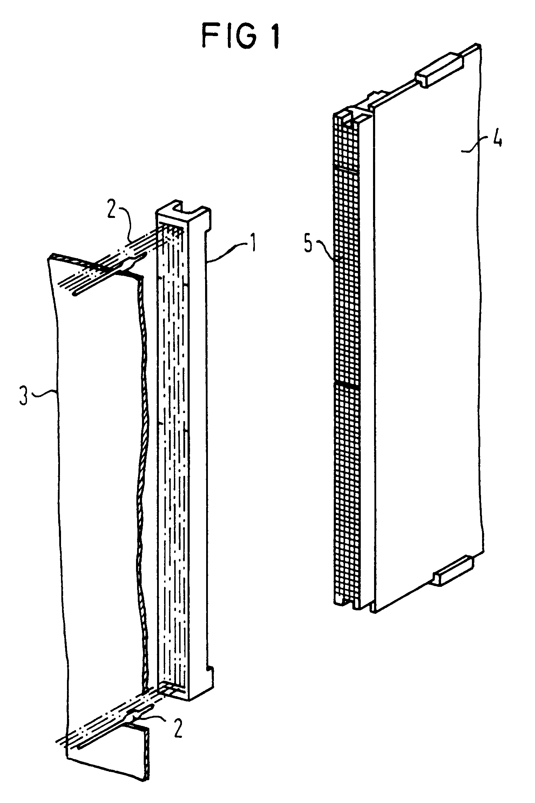

FIG 1 zeigt zum besseren Verständnis die prinzipielle Anordnung einer Rückwandverdrahtung, auf die elektrische Baugruppen aufsteckbar sind, um ein Anwendungsbeispiel für die vorliegende Erfindung zu geben. In dem dargestellten Beispiel soll die Rückwandleiterplatte mit in durchgehenden Rastern eingesetzten Kontaktmessern 2 (hier nicht dargestellt) versehen sein, auf welche Messerleisten 1 aufsteckbar sind. Diese Messerleisten 1 dienen zur Aufnahme von Federleisten 5, die fest mit Baugruppenleiterplatten 4 verbunden sind.

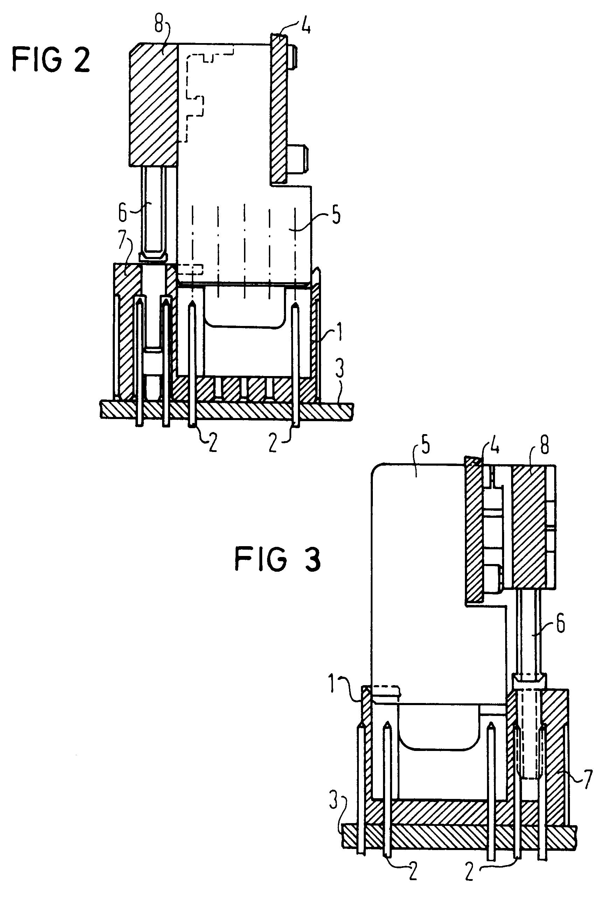

FIG 2 und FIG 3 zeigen Querschnitte durch eine Steckverbindung, bestehend aus Messer- und Federleiste, bei der nachträglich eine Codiervorrichtung gemäß der Erfindung angebracht worden ist.

Die eigentliche Steckverbindung besteht aus der Federleiste 5, die mit der Baugruppenleiterplatte 4 fest verbunden ist, sowie aus der Messerleiste 1 die auf das von den Kontaktmessern 2 gebildete Stiftfeld einer Rückwandleiterplatte 3 aufgesteckt ist. Die Codiervorrichtung besteht aus der Codierleiste 7, die neben der Messerleiste 1 auf das Stiftfeld aufgesteckt wird und wie die Messerleiste 1 durch den Kontakt mit den Stiften gehalten wird. Den Figuren läßt sich entnehmen, daß die Codierleiste 7 Vertiefungen zur Aufnahme der Kontaktmesser 2 sowohl innerhalb als auch in den Außenwänden aufweist. Dadurch ist es möglich die Codierleiste 7 an jeder Stelle der Rückwandleiterplatte 3 parallel zu einer Messerleiste 1 auf die Rückwandleiterplatte 3 aufzustecken.

Die Gegencodierung erfolgt auf der Baugruppe, und zwar durch Anbringen einer Gegencodierleiste 8, die entsprechende Codierstifte 6 aufweist. Auf das Prinzip der Codierung soll in diesem Zusammenhang nicht eingegangen werden, da dies nicht Gegenstand der vorliegenden Erfindung ist.

Wie sich den Figuren entnehmen läßt, kann die Gegencodierleiste 8 z.B. entweder einschnappbar am Federleistenkörper 5 oder im Flanschbereich der Federleiste 5 auf der Baugruppenleiterplatte 4 befestigt werden. Ebenso wäre es denkbar, die Gegencodierleisten 8 mit dem Federleistenkörper 5 bzw. der Baugruppenleiterplatte 4 zu verschrauben.

Eine andere in der Zeichnung nicht dargestellte Möglichkeit besteht darin, daß die Codierstifte in im Federleistenkörper 5 vorgesehenen Nuten einsetzbar sind. Dies bedeutet einen vergrösserten Aufwand bei der Herstellung der Codierung, ermöglicht aber im einzelnen eine große Freiheit bei der Herstellung einer individuellen Codierung.

## Patentansprüche

1. Codiervorrichtung für auf eine Rückwandverdrahtung aufsteckbare elektrische Baugruppen (4), wobei die Rückwandverdrahtung aus einer Rückwandleiterplatte (3) mit im durchgehenden Raster eingesetzten Kontaktmessern (2) und darauf aufsteckbaren, als einseitig offene, rechtwinklige Gehäuse ausgebildeten Messerleisten (1) zur Aufnahme von Federleisten (5), die mit elektrischen Baugruppen fest verbunden sind, besteht,
**dadurch gekennzeichnet**,
daß neben den Messerleisten (1) Kodierleisten (7) auf die Rückwandleiterplatte (3) aufsteckbar sind, die sowohl Vertiefungen zur Aufnahme von an den Federleisten (5) angebrachten und in Steckrichtung zeigenden Codierstiften (6) als auch Vertiefungen zur Aufnahme der Kontaktmesser (2) aufweisen.

2. Codiervorrichtung nach Anspruch 1,
**dadurch gekennzeichnet**,
daß die Codierstifte (6) Teile einer an dem Federleistenkörper anbringbaren Gegencodierleiste (8) sind.

3. Codiervorrichtung nach Anspruch 1,
**dadurch gekennzeichnet**,
daß die Codierstifte (6) einzeln in im Federleistenkörper (5) vorgesehenen Nuten einsetzbar sind.

## Claims

1. Coding device for electrical assemblies (4) which can be plugged onto a backplane wiring, in which the backplane wiring comprises a backplane printed circuit board (3) with contact blades (2) inserted in a continuous grid and blade connectors (1), which can be plugged thereon and which are designed as rectangular housings open at one side, to receive spring clips (5), which are fixedly connected to electrical assemblies, characterized in that beside the blade connectors (1), coding strips (7) can be plugged onto the backplane printed circuit board (3), which coding strips exhibit depressions to receive coding pins (6) attached to the spring clips (5) and pointing in the plug direction, and also depressions to receive the contact blades (2).

2. Coding device according to Claim 1, characterized in that the coding pins (6) are parts of a cooperating coding strip (8) which can be attached to the spring-clip member.

3. Coding device according to Claim 1, characterized in that the coding pins (6) can be individually inserted in grooves provided in the spring-clip member (5).

## Revendications

1. Dispositif de codage pour des modules électriques (4), qui peuvent être enfichés sur un câblage de paroi arrière, le câblage de paroi arrière étant constitué d'une plaque (3) de circuits imprimés de paroi arrière qui comporte des couteaux de contact (2) insérés selon un réseau continu et des règlettes de contacts à couteaux (1), qui peuvent être enfichées sur ces couteaux et ont la forme d'un boîtier à angles droits ouvert d'un côté, qui sert à loger des connecteurs à ressorts (5), qui sont reliées de façon fixe à des modules électriques,
caractérisé par le fait qu'outre des règlettes de contacts à couteaux (1), des barrettes de codage (7) peuvent être enfichées, sur la plaque de circuits imprimés (3) de paroi arrière, les barrettes de codage ayant à la fois des renfoncements servant à loger des tiges de codage (6) montées sur les connecteurs à ressorts (5) et dirigées dans la direction d'enfichage et des renfoncements servant à loger les couteaux de contact (2).

2. Dispositif de codage suivant la revendication 1, caractérisé par le fait que les tiges de codage (6) font partie d'une barrette de codage antagoniste (8) pouvant être montée sur le corps des connecteurs à ressorts.

3. Dispositif de codage suivant la revendication 1, caractérisé par le fait que les tiges de codage (6) peuvent être insérées individuellement dans des rainures prévues dans le corps (5) des connecteurs à ressorts.
